# EUROPEAN PATENT APPLICATION

(11) **EP 3 733 926 A1**
(43) Date of publication of application: **04.11.2020**
(21) Application number: 18895724.5
(22) Date of filing: 19.10.2018
(51) Int. Cl.: C23C 14/24, C23C 14/26, C23C 14/14

(54) **DEPOSITION APPARATUS AND DEPOSITION METHOD**

(30) Priority: 26.12.2017 KR 20170179178
(71) Applicant: POSCO, Gyeongsangbuk-do 37859 (KR)
(72) Inventor: NAM, Kyung-Hoon, Gwangyang-si, Jeollanam-do 57807 (KR); JUNG, Yong-Hwa, Gwangyang-si, Jeollanam-do 57807 (KR); EOM, Mun-Jong, Gwangyang-si, Jeollanam-do 57807 (KR); KIM, Tae-Yeob, Gwangyang-si, Jeollanam-do 57807 (KR); KO, Kyoung-Pil, Gwangyang-si, Jeollanam-do 57807 (KR); JUNG, Woo-Sung, Gwangyang-si, Jeollanam-do 57807 (KR)
(74) Representative: Zech, Stefan Markus
(86) International application number: PCT/KR2018/012451
(87) International publication number: WO 2019/132206

(57) **Abstract**

The present invention provides an apparatus and a method that is capable of performing continuous coating at a constant coating composition and rate. One embodiment is a deposition apparatus for coating two or more compounds or elements on a substrate, the apparatus comprising: a supply unit for supplying the two or more compounds or elements to a plurality of solid bodies; a heating unit for melting and evaporating the solid bodies supplied from the supply unit to form vapor; a buffer unit, connected to the heating unit, in which the vapor stays and is mixed with previously generated vapor; and a nozzle connected to the buffer unit and having an opening toward the substrate.

## Description

### [Technical Field]

The present disclosure relates to a deposition apparatus and a deposition method for coating two or more compounds or elements.

### [Background Art]

Techniques for coating by vacuum deposition began to be widely used in the 1980s. Looking at the known technology, it can be largely divided into a simultaneous deposition method and a heat treatment method after the subsequent deposition process.

A representative technique of the simultaneous deposition method is known from Japanese patent JPH02-125866A2. As a deposition apparatus for coating alloys of two metals with different vapor pressures, a dedicated evaporator for each metal (zinc and magnesium) is installed, and a throttle valve is installed to control a flow rate of evaporated metal vapor at an outlet of each evaporator. In order to control the composition of the coated alloy by controlling each evaporation flow rate, using the throttle valve mounted on the zinc and magnesium evaporators, the composition is uniformly mixed in a width direction in a portion where each of the evaporated metals are combined, which is very difficult on a flow of the fluid. In order to overcome this weakness, in European patent EP1301649B1, uniform mixing was attempted by maintaining choking conditions before or after mixing of metal vapors, but there are also practical limitations.

A technique for heat treatment after sequential deposition is disclosed in European patent EP0756022B1. After coating zinc using wet plating or a vacuum deposition method, magnesium is coated by the vacuum plating method and post-heat treatment to form a zinc-magnesium alloy coating layer. The above-described technique is a technique using diffusion, and has a disadvantage in that a composition of the coating layer in a depth direction is not uniform and an alloy between a base material and zinc by heat treatment is generated. In addition, the number of processes for alloy coating is increased, which is limited in terms of economic efficiency.

### [Disclosure]

### [Technical Problem]

The present disclosure is to provide an apparatus and a method that is capable of performing continuous coating at a constant coating composition and rate.

### [Technical Solution]

The present disclosure is to provide a deposition apparatus and a deposition method as follows.

According to an aspect of the present disclosure, a deposition apparatus for coating two or more compounds or elements on a substrate is provided. The deposition apparatus includes: a supply unit for supplying the two or more compounds or elements to a plurality of solid bodies; a heating unit for melting and evaporating the solid bodies supplied from the supply unit to form vapor; a buffer unit, connected to the heating unit, in which the vapor remains and is mixed with previously generated vapor; and a nozzle connected to the buffer unit and having an opening toward the substrate.

According to an aspect of the present disclosure, the supply unit supplies a solid body to the heating unit through a supply pipe, the supply pipe may include an end portion facing the heating unit, the end portion extending into molten metal of the heating unit, and an opening, smaller than a cross-section of the solid body may be formed in the end portion of the supply pipe facing the heating unit so that the supplied solid body is at least partially melted by the molten metal and is then discharged from the supply pipe.

According to an embodiment of the present disclosure, the heating unit includes a crucible, and the buffer unit is a space connecting the nozzle and the crucible, wherein an area of the opening may be smaller than a cross-section of the crucible.

According to an embodiment of the present disclosure, the supply unit may include a first supply unit for supplying a first solid body and a second supply unit for supplying a second solid body having a different element or compound from the first solid body. In this case, the first supply unit and the second supply unit may supply a solid body to the heating unit through a single supply pipe.

According to an embodiment of the present disclosure, the first supply unit and the second supply unit may be disposed in a portion above the heating unit, so that the solid body in the supply pipe may be supplied to the heating unit by its own weight.

According to an embodiment of the present disclosure, the heating unit may include a crucible and an electromagnetic coil disposed inside or outside of the crucible, and the electromagnetic coil may be a non-floating induction heating unit, and may be wound in a vertical direction.

In an embodiment, each of the first solid body and the second solid body may include one or more of zinc, magnesium, aluminum, lithium, indium, silver, and copper.

According to another embodiment of the present disclosure, a deposition method is provided. The deposition method includes: a supply operation for supplying two or more solid bodies to one heating unit simultaneously; a vapor forming operation for forming vapor by melting and evaporating the solid body; a buffer operation in which the vapor and the previously formed vapor are mixed; and a spraying operation for spraying the mixed vapor toward a coated material.

According to an embodiment of the present disclosure, the solid body may include one or more of zinc, magnesium, aluminum, lithium, indium, silver, and copper, and the mixed vapor and the solid body may have different compositions from each other.

According to an embodiment of the present disclosure, a composition ratio of the entire solid body supplied in the supply operation may be identical to a composition ratio of a target coating layer. In the supply operation, the solid body may be supplied through a supply pipe extending into molten metal of the crucible, and in the vapor forming operation, the solid body may be melted, and be then discharged from the supply pipe and mixed with the molten metal.

According to an embodiment of the present disclosure, each of the solid bodies may include only one of zinc, magnesium, aluminum, lithium, indium, silver, and copper, and the composition ratio of the entire solid body supplied in the supply operation is identical to the composition ratio of the target coating layer.

### [Advantageous Effects]

According to the present disclosure, continuous coating may be performed through the coating composition and speed through the configuration as described above.

### [Description of Drawings]

FIG. 1 is a schematic view of an embodiment of the present disclosure.
FIG. 2 is a schematic view of another embodiment of the present disclosure.
FIG. 3 is a cross-sectional view of the present disclosure.
FIG. 4 is a view illustrating a modification example of an electromagnetic coil of the embodiment of FIG. 3.
FIG. 5 is a graph showing the coating speed when the type of the electromagnetic coil is changed in the embodiment of FIG. 3.
FIG. 6 is a simulation view simulating a flow of vapor in a buffer unit of the embodiment of FIG. 3.
FIG. 7 is a view illustrating a modification example of a nozzle of the embodiment of FIG. 3.
FIG. 8 is a cross-sectional view of an end portion of a supply pipe of the embodiment of FIG. 3.
FIG. 9 is a graph illustrating a coating speed to a shape of an end portion of a supply pipe.
FIG. 10 is a schematic view of a deposition method of the present disclosure.

### [Mode for Invention]

Hereinafter, specific embodiments of the present disclosure will be described with reference to the drawings.

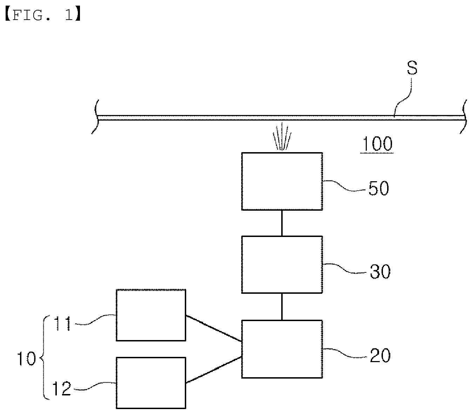

In FIG. 1, a schematic view of a deposition apparatus of the present disclosure is illustrated.

A deposition apparatus in an embodiment of the present disclosure is a deposition apparatus 100 for coating two or more compounds or elements on a substrate S. The deposition apparatus 100 includes a supply unit 10 for supplying the two or more compounds or elements to a plurality of solid bodies; a heating unit 20 connected to the supply unit 10, and for melting and evaporating the solid bodies supplied from the supply unit to form vapor; a buffer unit 30, connected to the heating unit, in which the vapor remains and is mixed with previously generated vapor; and a nozzle 50 connected to the buffer unit and having an opening toward a substrate S.

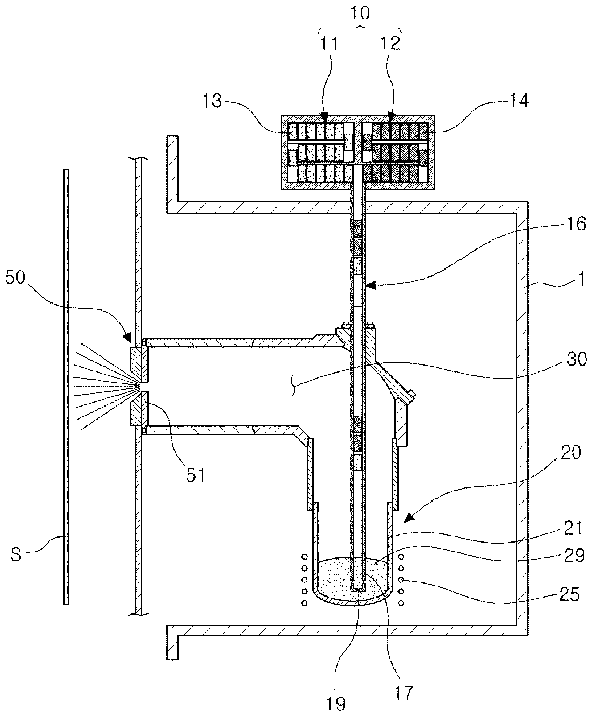

In an embodiment of FIG. 1, the supply unit 10 includes a first supply unit 11 for supplying a first solid body 13 (see FIG. 3) and a second supply unit 12 for supplying a second solid body 14 (see FIG. 3). In the present disclosure, two or more compounds or elements are coated on the substrate S, and the first solid body and the second solid body use a solid body having a composition different from the target coating layer coated on the substrate. For example, when zinc and magnesium alloys are coated with a specific composition, zinc may be used as the first solid body, and magnesium may be used as the second body, and the composition of the zinc-magnesium alloy may be adjusted by controlling an amount of the supplied solid body.

The solid body may include any one or more of zinc, magnesium, aluminum, lithium, indium, silver, and copper, and may be made of only one metal element. In an embodiment of the present disclosure, it is possible to form a coating layer having another composition with two solid bodies having different composition ratios. In particular, it may be difficult that a solid body having the same composition ratio as the coating layer is manufactured, but in the present disclosure, the composition ratio of the target coating layer may be matched to an entirety of a plurality of solid bodies, such that it is possible to match the composition ratio of the target coating layer by controlling an amount of the number supplied with the solid body facilitating manufacturing.

Meanwhile, in this embodiment, the supply unit 10 provides the first and second solid bodies to the heating unit 20 simultaneously. Here, 'simultaneously' means that the first and second solid bodies are supplied at the same timing, and the first and second solid bodies are successively supplied to supply the first and second solid bodies at substantially one timing.

The heating unit 20 includes a crucible capable of receiving and melting/evaporating the supplied solid body and heating body providing heat to the solid body inside the crucible. In this embodiment, it is preferable that a certain amount of molten metal is maintained in the crucible of the heating unit 20 to enable continuous coating, and heat is transferred to the solid body through the molten metal to melt the solid body. The heating body may be composed of an electromagnetic coil to allow electromagnetic stirring at the same time as heating, and the coil may be disposed anywhere inside or outside of the crucible.

The vapor generated in the heating unit 20 passes through the buffer unit 30 and is then distributed to the substrate S, for example a strip, through the nozzle 50. The buffer unit 30 may be provided on a path through which the vapor generated from the heating unit, and be composed of a space unit for maintaining vapor, such that the vapor just generated in the heating unit 20 and the vapor previously generated may be mixed. In this embodiment, the solid body is melted and evaporated, and the timing of melting and evaporation of the solid body may be different due to the composition, and thus vapor different from the composition ratio of the target coating layer may be temporarily generated.

However, since the composition ratio of the entire solid body supplied by the present disclosure is the same as the composition ratio of the target coating layer, when all of the supplied solid bodies are evaporated, the composition ratio of the entire solid body supplied by the present disclosure may be the same as the target composition ratio.

In an embodiment of the present disclosure, in the buffer unit, vapor is not directly discharged through the nozzle but is mixed with the subsequent vapor while staying for a certain period of time, so the vapor discharged from the buffer unit may pass the nozzle 50 with a constant compositional ratio, unlike the generated vapor.

The buffer unit 30 may maintain internal pressure of the buffer unit 30 to be higher than external pressure of the buffer unit 30, such that the vapor input into the buffer unit 30 may not be immediately discharged, but may be mixed with the subsequent vapor inside the buffer unit 30. In addition, heat may be provided to the vapor by providing a heat source outside of or inside the buffer unit 30 so that vapor does not condense inside the buffer unit 30.

The buffer unit 30 is connected to a nozzle 50. The nozzle 50 sprays the vapor that has passed through the buffer unit 30 through an opening, and the vapor sprayed from the nozzle 50 is deposited on the substrate S to form a coating layer. The nozzle 50 may also be heated to prevent condensation of vapor passing through the same as the buffer unit 40.

The heating unit 20, the buffer unit 30, and the nozzle 50 are disposed in a vacuum state inside a vacuum chamber.

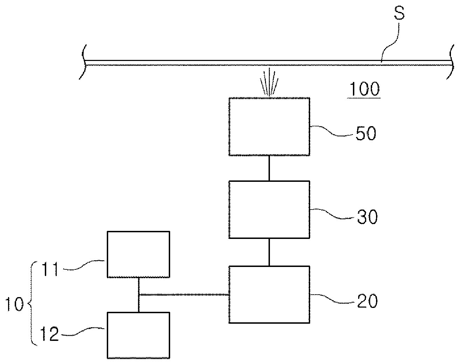

In FIG. 2, another embodiment of the present disclosure is illustrated. In an embodiment of FIG. 2, the configuration of the heating unit 20, the buffer unit 30 and the nozzle 50 is the same as the embodiment of FIG. 1, but it is configured such that the first supply unit 11 and the second supply unit 12 of the supply unit 10 does not separately supply a solid body to the heating unit 20, but the solid body of the first supply unit 11 and the solid body of the second supply unit 12 are supplied to the heating unit 20 through one path.

In this case, any one of the solid bodies of the first supply unit and the second supply unit 11 and 12 is first supplied to the heating unit 20, and then the solid body of the other supply unit is successively supplied, and when the first supplied solid body is melted, a composition ratio of molten metal may fluctuate and a composition ratio of the generated vapor may not be identical to the composition ratio of the target coating layer.

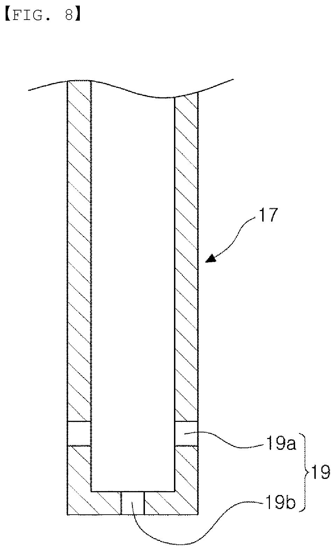

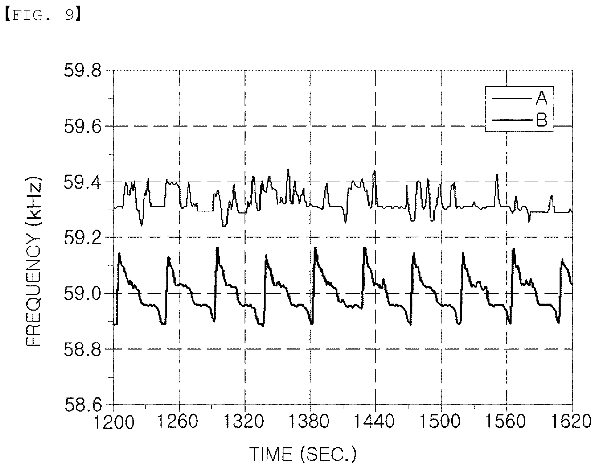

In FIG. 3, a cross-sectional view of the embodiment of FIG. 2 is illustrated. As shown in FIG. 3, the supply unit 10 is disposed outside of a vacuum chamber 1, and the supply unit 10 includes a first supply unit 11 for supplying a first solid body 13, a second supply unit 12 for supplying a second solid body 14, and a supply pipe 16 connected to the first supply pipe 11 and the second supply pipe 12, and extending into the non-conductive crucible 21 through the vacuum chamber 1. The supply pipe 16 is formed in a vertical direction so that the solid bodies 13 and 14 supplied to the supply pipe 16 can be moved to an end portion facing the heating unit by their own weights. An opening 19 is formed in the end portion 17 of the supply pipe 16, the end portion facing the heating unit. This will be described with reference to FIGS. 8 and 9.

A cross-sectional view of an end portion 17 of a supply pipe 16, the end portion facing the heating unit, is illustrated in FIG. 8, and in FIG. 9, a case in which the supply pipe 16 is used and a case in which a general supply pipe is used is illustrated. As shown in FIG. 8, openings 19a and 19b are formed on a lower surface and a side surface of the end portion 17 of the supply pipe 16, the end portion 17 facing the heating unit. In this case, the openings 19a and 19b are formed to be smaller than cross-sections of the first and second solid bodies 13 and 14 not to fall directly into the openings 19a and 19b when the solid bodies 13 and 14 introduced to the end portion 17. The plurality of openings 19a and 19b may be provided, and the openings 19a and 19b may be provided to have different sizes.

Since molten metal 29 can be introduced and discharged through the openings 19a and 19b, the molten metal 29 is filled inside the end portion 17, and the solid bodies 13 and 14 are melted by the molten metal 29. Therefore, the solid bodies 13 and 14 are melted in a liquid state or a solid state of a small size in the molten metal 29, and it can be prevented that the temperature and volume of the molten metal 29 are rapidly changed in a mixing process.

In FIG. 9, A shows that when a solid body was supplied according to the opening of FIG. 8, and B shows that when an end portion of a supply pipe 16 was opened and the solid body is directly was mixed into the molten metal 29. Zinc and magnesium was used as a solid body, and a zinc solid body and a magnesium solid body were supplied every 45 seconds. An induction heating unit 25 used the same induction heating unit.

As shown in FIG. 9, it can be confirmed that a fluctuation width of a frequency was small in A, but in B, the frequency fluctuates significantly. In addition, it can be confirmed that in A, the frequency fluctuates within a certain range regardless of a supply cycle, but in B, the frequency fluctuates significantly every supply cycle. Since the frequency of the induction heating unit fluctuates depending on the volume of the molten metal 29, it can be seen that in A, a width of volume fluctuation of the molten metal 29 is not large, and thus, it can be seen that a surface area and a temperature of the molten metal 29 is low, to provide a constant amount of evaporation.

Returning to FIG. 3, the heating unit 20 includes a crucible 21 disposed inside the vacuum chamber 1 and is a non-conductive container and an induction heating unit 25 disposed outside of the crucible 21 and is wound around the crucible 21. A certain amount of molten metal 29 in which the first and second solid bodies 13 and 14 are melted during an operation is maintained inside the crucible 21, and the end portion 17 of the heating unit of the supply pipe 16 extends into the molten metal 29, and is disposed such that at least an opening 19 is immersed in the molten metal.

In order to perform alloy/compound coating of a constant coating composition and speed, in particular, in order to achieve evaporation of two elements having different vapor pressures, stirring of the molten metal 29 is required to overcome the difference in vapor pressures, and the induction heating unit 25 is provided to be induction-heated while stirring the molten metal 29 received in the crucible 21. A composition ration of an upper portion and an inner portion of an evaporation surface may be maintained to be the same by the electromagnetic stirring of the induction heating unit 25. The induction heating unit 25 may be located inside a vacuum, or may be located in air by installing a partition wall as an electrical non-conductor between the induction heating unit 25 and the crucible 21.

In general, an electromagnetic force generated by the electromagnetic coil has a property of heating stirring, and floating the metal located therein. In the induction heating unit 25 of this embodiment, an important function is heating and stirring of the molten metal 29 by the electromagnetic force, and the floating function is not important. Therefore, the induction heating unit 25 of the present disclosure may employ a non-floating electromagnetic coil, rather than a floating electromagnetic coil.

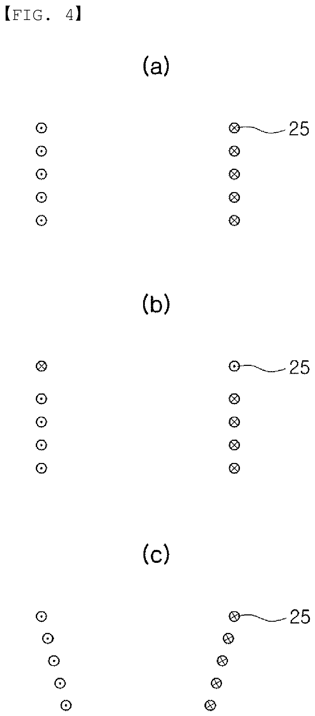

The shape of the non-floating induction heating unit 25 is illustrated in FIG. 4. As shown in FIG. 4, various types such as a vertical type, a V type, and the like may be used, and the number of windings may vary, such as 2 or 5 turns, and a winding method may also use various forms such as a type of unidirectional winding, a type of bidirectional winding, and the like.

Meanwhile, as presented in the Republic of Korea Patent 2009-0092627, the floating induction heating unit may be formed such that a diameter of a wire decreases toward a lower portion and a diameter of a bottom wire is formed very narrow, to impart a floating function. The floating-induction heating unit has disadvantages in that heating efficiency of the molten metal 29 is low due to lower concentration of the electromagnetic force for floating, and a flow of a coolant is not smooth due to the narrow diameter of the wire of the lower portion, so that a high current cannot be applied. Therefore, it is advantageous that the non-floating induction heating unit is applied from a viewpoint of a practical coating performance.

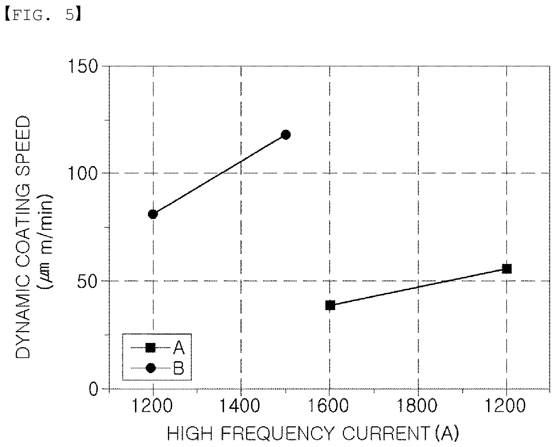

FIG. 5 shows a result of comparing a dynamic coating speed coated with a substrate using a non-floating induction heating unit and a floating induction heating unit. A coating layer is a zinc-magnesium alloy. An upper diameter of the induction heating unit 25 is equal to 180mm, and the floating induction heating unit has a shape of A in FIG. 4, and the non-floating induction heating unit has a shape in which a lower diameter thereof decreases. As shown in FIG. 5, it can be confirmed that a coating speed is much higher in an example in which the non-floating induction heating unit is applied even though a current, much lower than a high frequency current applied to the floating induction heating unit is applied. Therefore, in an embodiment of the present disclosure, a non-floating induction heating unit was used to provide a high coating speed.

Returning to FIG. 3 again, the buffer unit 30 is located above the crucible 21. The buffer unit 30 is formed of a space unit having a predetermined area, but the internal pressure of the buffer unit 30 is higher than the external pressure of the buffer unit 30. In the present embodiment, since the substrate S is standing in a vertical direction, the nozzle 50 is disposed to spray in a horizontal direction, and the buffer unit 30 disposed above the crucible 21 is formed as a space unit having an '¬' shape.

It is configured that an upper surface area of the molten metal 29, which is an evaporation area, that is, an area of the opening 51 of the nozzle 50 is smaller than a cross-sectional area of the crucible 21 so that the internal pressure is higher than the external pressure in the buffer unit 30. Since the area of the opening 51 is smaller than the evaporation area, the generated vapor is not immediately discharged and remains in the buffer unit 30 for a constant time.

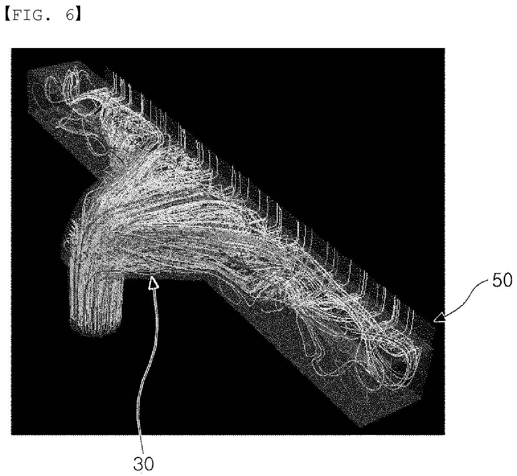

FIG. 6 is a simulation view for simulating the vapor flow passing through the buffer unit 30 to move to the nozzle 50, and it can be seen that the vapor discharged from the heating unit 20 is rotated inside the buffer unit 30. Therefore, a constant composition ratio can be maintained by mixing the vapor generated first and the vapor generated later.

Finally, the buffer unit 30 is connected to the nozzle 50. The nozzle 50 may have various types of openings 51, and may adopt an appropriate shape depending on the target substrate or conditions. As described above, the opening 51 must have a total area smaller than the evaporation area.

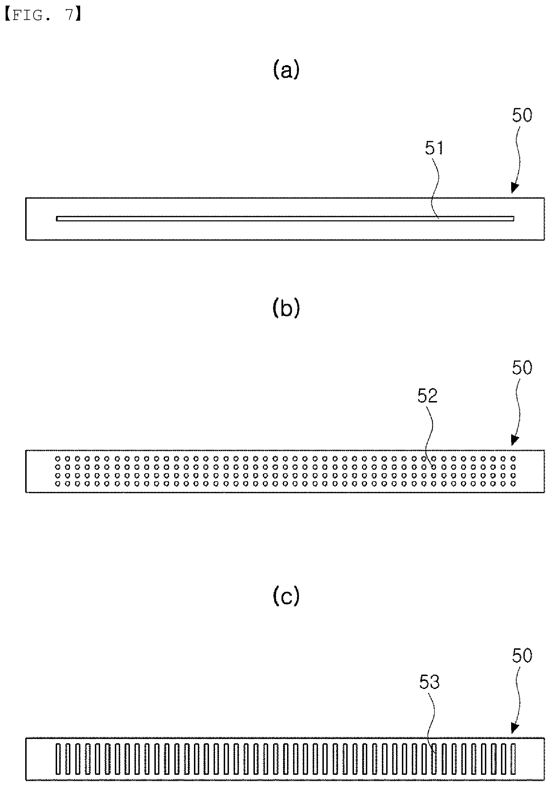

Various shapes of the nozzle are shown in FIG. 7. As shown in FIG. 7, slit-shaped openings 51 and 53 formed in a width direction or a height direction of the substrate (see A and C in FIG. 7), or a circular opening 52 disposed to be spaced apart by regular intervals (see B in FIG. 7) may also be illustrated.

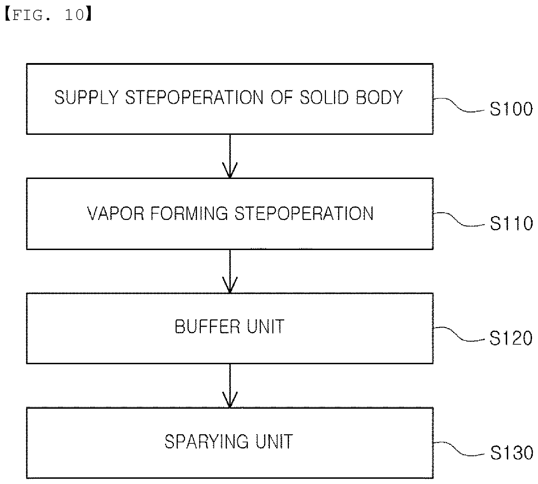

A flow chart of another deposition method according to an embodiment of the present disclosure is illustrated in FIG. 10. The deposition method of the present disclosure includes a supply operation for supplying two or more solid bodies to one heating unit (S100); a vapor forming operation for melting and evaporating the solid body to form vapor (S110); a buffer operation in which the vapor and the previously formed vapor are mixed (S120); and a spraying unit for spraying the mixed vapor onto a substrate (S130).

In the supply operation (S100), the solid bodies may include any one or more of zinc, magnesium, aluminum, lithium, indium, silver, and copper, and may be made of only one metal element. Therefore, it is possible to form a coating layer having another composition ratio with two solid bodies having different composition ratios. In the supply operation (S100), a solid body is supplied so that a composition ratio of the entire solid body to be supplied is identical to a composition ratio of a target coating layer.

In addition, in the supply operation (S100), the solid body is supplied through a supply pipe extending into molten metal of a crucible in which the solid body is received and melted and evaporated. In the vapor forming operation (S110), at least a portion of the solid body is formed is melted and is then discharged from the supply pipe and mixes with the molten metal.

In the vapor forming operation (S110), it is advantageous that stirring and heating of the molten metal are performed simultaneously to be evaporated at a constant adjustment ratio. Therefore, it is preferable to dispose an induction heating unit outside of the crucible to simultaneously perform stirring and heating of the molten metal, but is not limited thereto, and a stirring unit and a heating unit may be configured separately.

The buffer operation (S120) is a operation in which the vapor generated in the vapor forming operation (S110) is mixed with the previously generated vapor, and in which the internal pressure is higher than the external pressure, so that the vapor does not immediately be discharged through a nozzle and remains mixed in the apparatus. Due to the buffer operation (S120), it is possible to form a coating layer with vapor having a constant composition ratio by buffering deviations in the composition ratio generated during melting/evaporation of the solid body.

The spraying operation (S130) is an operation in which mixed vapor is sprayed through the nozzle of the deposition apparatus, and in which the vapor is deposited on a substrate to form a coating layer on the substrate. In the spraying operation, since the vapor mixed in the buffer operation (S120) is supplied, a coating layer is formed at a constant composition ratio.

### <Example>

Results of experiments with the apparatus of the embodiment of FIG. 3 are as follows. As a solid body, two types of pure zinc and pure magnesium were used, and a target coating layer was an alloy coating of zinc and magnesium (weight ratio: 10.8 wt% Mg).

As a crucible 21, a non-conductive container made of a ceramic material was used. Initially, 2 kg of a zinc-magnesium alloy was placed into the container, and induction heating was performed using an induction heating unit 25 to form molten metal. An inner diameter of the container was set to 140 mm, and a cross-sectional area of the opening 51 of the nozzle 50 through which the vapor is sprayed was set to be 7,000 mm² in total, so that it was configured such that the vapor is mixed in the buffer unit 30. In addition, a heater was used around the nozzle 50 and the buffer unit 30 to heat it to 800°C or higher.

To supplement the alloy molten metal consumed by evaporation, 61.2 g of two pure zinc solid bodies and 14.8 g of one pure magnesium solid body are supplied into the molten metal 29 through the supply unit 10. A total of three solid bodies (two pure zinc + one pure magnesium) were continuously introduced one by one, and an introduction time interval thereof was about 13.5 seconds. It is possible to continuously coat zinc and magnesium alloys on a substrate with a uniform composition and a uniform rate of 10 g/s by using such a deposition apparatus 100 and a deposition method.

The composition of the initial alloy that is introduced into the non-conductive container is not related to a coating composition. When if only a composition of the supplied raw material is the same as the coating composition, other compositions may be coated at the beginning of the coating, but as time passes, coating of a desired composition can be stably performed at a uniform rate as soon.

## Claims

1. A deposition apparatus for coating two or more compounds or elements on a substrate, the substrate comprising:
a supply unit for supplying the two or more compounds or elements to a plurality of solid bodies;
a heating unit for melting and evaporating the solid bodies supplied from the supply unit to form vapor;
a buffer unit, connected to the heating unit, in which the vapor remains and is mixed with previously generated vapor; and
a nozzle connected to the buffer unit and having an opening toward a substrate.

2. The deposition apparatus of claim 1, wherein the supply unit supplies a solid body to the heating unit, and
the supply pipe comprises an end portion facing the heating unit extending into molten metal of the heating unit.

3. The deposition apparatus of claim 2, wherein an opening, smaller than a cross-section of the solid body is formed in the end portion of the supply pipe, the end portion facing the heating unit, such that the supplied solid body is partially melted by the molten metal and is then discharged from the supply pipe.

4. The deposition apparatus of any one of claims 1 to 3, wherein the heating unit comprises a crucible, and
the buffer unit is a space connecting the nozzle and the crucible, wherein an area of the opening is smaller than a cross-section of the crucible.

5. The deposition apparatus of claims 2 or 3, wherein the supply unit comprises a first supply unit for supplying a first solid body; and a second supply unit for supplying a second solid body having a different element or compound from the first solid body.

6. The deposition apparatus of claim 5, wherein the first supply unit and the second supply unit supply a solid body to the heating unit through the one supply pipe.

7. The deposition apparatus of claim 6, wherein the first supply unit and the second supply unit is located above the heating unit, and the solid body is supplied to the heating unit by its own weight in the supply pipe.

8. The deposition apparatus of any one of claims 1 to 3, wherein the heating unit comprises a crucible and an electromagnetic coil disposed inside or outside of the crucible.

9. The deposition apparatus of claim 8, wherein the electromagnetic coil is a non-floating induction heating unit.

10. The deposition apparatus of claim 8, wherein the electromagnetic coil is wound in a vertical direction.

11. The deposition apparatus of claim 5, wherein each of the first solid body and the second solid body comprises one or more of zinc, magnesium, aluminum, lithium, indium, silver, and copper.

12. A deposition method, comprising:
a supply operation for supplying two or more solid bodies to one heating unit simultaneously;
a vapor forming operation for forming vapor by melting and evaporating the solid body;
a buffer operation in which the vapor and the previously formed vapor are mixed; and
a spraying operation for spraying the mixed vapor toward a substrate.

13. The deposition method of claim 12, wherein the solid body comprises one or more of zinc, magnesium, aluminum, lithium, indium, silver and copper, and
the mixed vapor and the solid body have a different composition from each other.

14. The deposition method of claim 13, wherein a composition ratio of the entire solid body supplied in the supply operation is identical to a composition ratio of a target coating layer.

15. The deposition method of claim 12, wherein in the supply operation, the solid body is supplied through a supply pipe extending into molten metal of a crucible in which the solid body is received and melted and evaporated, and
in the vapor forming operation, the solid body is at least partially melted and is then discharged from the supply pipe and mixed with the molten metal.

16. The deposition method of claim 12, wherein each of the solid body comprises only one of zinc, magnesium, aluminum, lithium, indium, silver, and copper, and
a composition ratio of the entire solid body supplied in the supply operation is identical to a composition ratio of the target coating layer.
